(19) **Europäisches Patentamt**
**European Patent Office**
**Office européen des brevets**

(11) **EP 1 589 666 B1**

(12) **EUROPEAN PATENT SPECIFICATION**

(45) Date of publication and mention
of the grant of the patent:
**28.03.2012 Bulletin 2012/13**

(51) Int Cl.:
*H04B 1/04* *(2006.01)*   *H04B 17/00* *(2006.01)*

(21) Application number: **04009223.1**

(22) Date of filing: **19.04.2004**

(54) **Method for correcting a mobile telephone having an automatic power control function and a correction system therefor**

Verfahren zur Korrektur der automatischen Leistungsregelungsfunktion eines Mobiltelefons und System dafür

Procédé pour la correction d'un téléphone mobile ayant une fonction automatique de régulation de puissance et système de correction correspondant

(84) Designated Contracting States:
**DE FR GB**

(43) Date of publication of application:
**26.10.2005 Bulletin 2005/43**

(73) Proprietor: **HTC Corporation**
**Taoyuan County 330 (TW)**

(72) Inventor: **Huang, Jun-Da**
**Taoyuan (TW)**

(74) Representative: **Weber, Joachim**
**Hoefer & Partner**
**Patentanwälte**
**Pilgersheimer Strasse 20**
**81543 München (DE)**

(56) References cited:
**GB-A- 2 393 595**     **US-A1- 2002 127 980**
**US-A1- 2003 060 179**

**Description**

BACKGROUND OF THE INVENTION

Field of the Invention

The invention relates to a correction method and a correction system, and more particularly to a method for correcting a mobile telephone having an automatic power control function and a correction system therefor.

Description of the Related Art

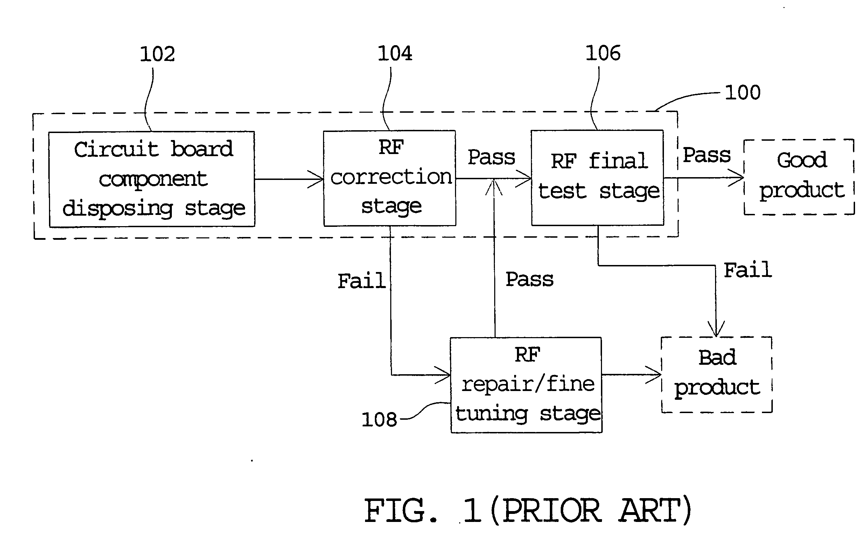

FIG. 1 is a schematic illustration showing a conventional production line 100 for performing a radio frequency (RF) correction. The production and correction flows for typical mobile telephones are as follows. First, a main component of a mobile telephone, which includes a device under test (DUT) such as an RF antenna, is mounted to a circuit board in a circuit board component disposing stage 102. Then, in an RF correction stage 104, the output power of the RF antenna is corrected. If the output power of the RF antenna does not satisfy the communication specification such as the ETSI (European Telecommunications Standards Institute) power control specification, the circuit board is transferred to an RF repair/fine tuning stage 108 outside the production line 100. If the output power of the RF antenna satisfies the communication specification, the circuit board is transferred to an RF final test stage 106. On the other hand, in the RF repair/fine tuning stage 108, the circuit board is repaired, and the output power of the RF antenna is finely tuned. If the repair succeeds, the circuit board is transferred to the RF final test stage 106; or otherwise, the circuit board is categorized as a defected part. In the RF final test stage 106, the circuit board is first assembled in the mobile telephone, and the overall mobile telephone is then subjected to a final test. If the mobile telephone passes the final test, the mobile telephone is categorized as a good product, or otherwise as a defected product.

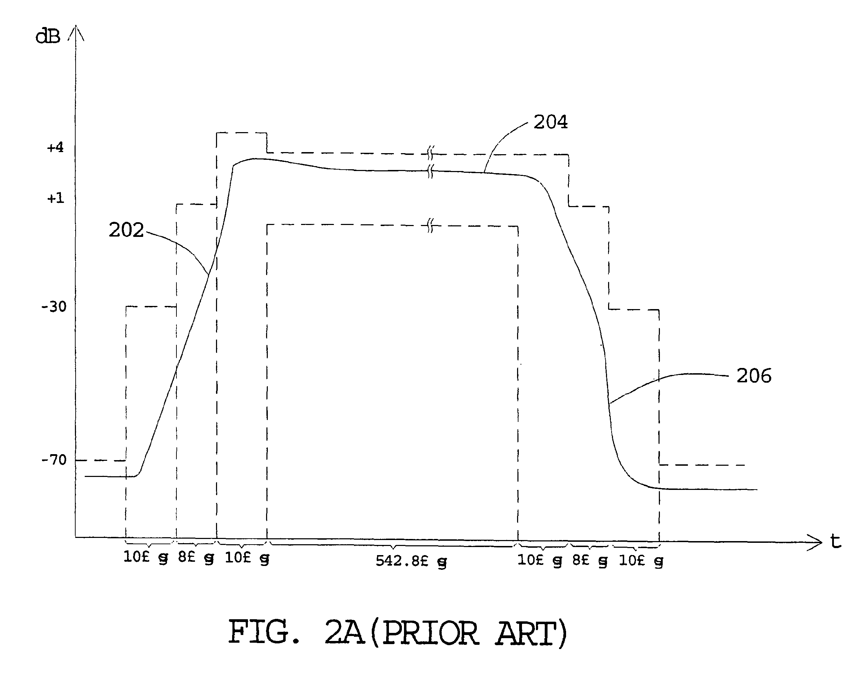

In the GSM system, each TDMA (Time Division Multiple Access) code frame is divided into several time slots, each of which is referred to as a burst. FIG. 2A is a graph showing a relationship between a power of the burst with respect to time. As shown in FIG. 2A, each burst may be divided into three portions including a ramp up portion 202, a burst portion 204 and a ramp down portion 206. In ETSI, the power of the burst portion 204 may have 32 power levels, which are controlled by 32 power control levels, respectively.

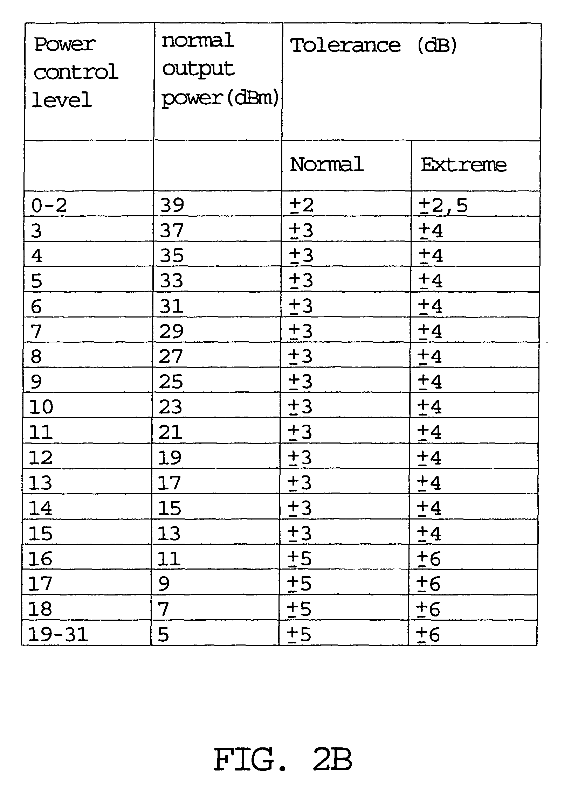

FIG. 2B shows a look-up table created according to 32 power control levels and the normal output powers of the mobile telephone in the GSM400/GSM900/GSM850 system. In FIG. 2B, the normal tolerances and extreme tolerances of the normal output powers are further illustrated. When the mobile telephone has the APC (automatic power control) function, the base transceiver station momentarily commands the mobile telephone to automatically adjust the emitting power of the radio signal thereof according to the condition of the received radio signal. That is, the mobile telephone automatically selects different power control levels to generate a proper output power for communication with the base transceiver station according to the distance from the base transceiver station to the mobile telephone.

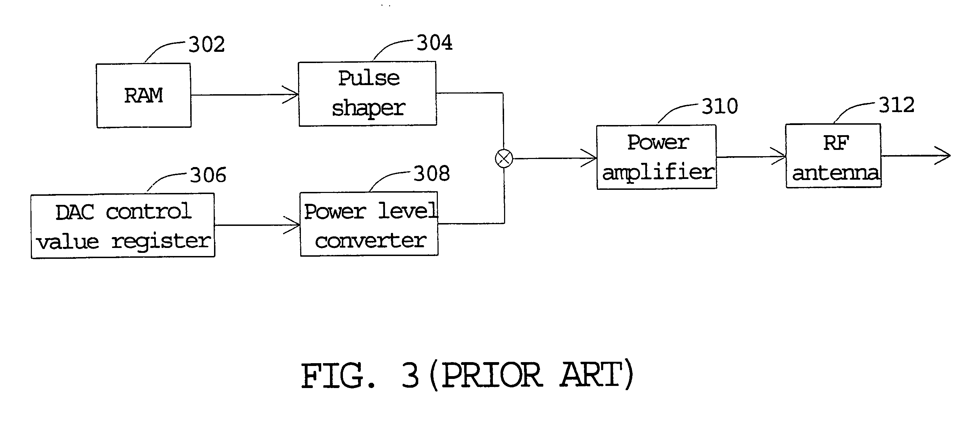

FIG. 3 is a block diagram showing a portion of the system of the mobile telephone for generating the burst of FIG. 2A. The random access memory (RAM) 302 has stored multiple sets of words. A pulse shaper 304 processes the words to generate voltages corresponding to the ramp up portion 202 and the ramp down portion 206 of the burst of FIG. 2A. The DAC (digital-to-analog conversion) control value register 306 has stored 32 DAC control values corresponding to 32 power control levels. The power level converter 308 selects one of the 32 DAC control values stored in the DAC control value register 306, and generates corresponding voltages. The output voltage of the pulse shaper 304 is multiplied by the output voltage of the power level converter 308 to obtain a product, which is processed by the power amplifier 310 to generate a signal for controlling the RF antenna 312 to make the RF antenna 312 generate an output power corresponding to the selected DAC control value.

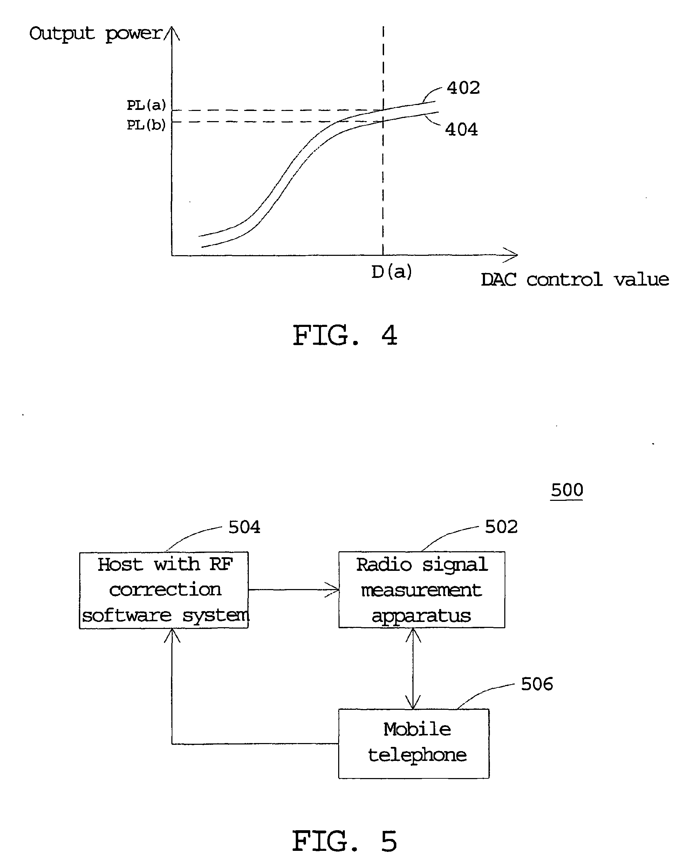

However, the DAC control values corresponding to 32 output powers are different because the types of the mobile telephones are different. In particular, owing to the difference in the manufacturing processes, the same DAC control value may even cause the mobile telephones of the same type to generate different output powers. FIG. 4 illustrates characteristic curves 402 and 404 corresponding to two mobile telephones, respectively. Even if the DAC control values are equal to D(a), the output powers of the two mobile telephones are PL(a) and PL(b), respectively. Hence, during the manufacturing processes, the mobile telephones have to be corrected in the RF correction stage 104 of FIG. 1. In the prior art, the parameters of the mobile telephone are adjusted to make the output powers of the mobile telephone satisfy the communication specification by try and error. If the correction cannot succeed, the mobile telephone usually has to be repaired and finely tuned in the RF repair/fine tuning stage 108 outside the production line 100. However, the conventional correction method is quite time-consuming, and the yield thereof is not high.

GB 2 393 595 A discloses a calibration method to enable accurate power control. According to fig. 5, a look up-table is generated, which includes a current control voltage $V_{control}$ for any required value of output power P. Current control voltages $V_{control}$ for output powers between the output powers available in the look-up table can be find via an interpolation and/or extrapolation.

SUMMARY OF THE INVENTION

It is therefore an object of the invention to provide a method for correcting a mobile telephone having an automatic power control function and a correction system therefor, wherein the correction may be quickly performed, and the product yield may be greatly and advantageously enhanced.

The invention achieves the above-identified object by providing a method for correcting a mobile telephone having an automatic power control function. The method corrects I output powers of an antenna corresponding to I power control levels of a mobile telephone, wherein I is a positive integer. I DAC (digital-to-analog conversion) control values for determining I output powers are stored in the mobile telephone. The correction method of the invention includes the following steps. First, K DAC control values for test are arbitrarily selected, and K output powers for test of the mobile telephone corresponding to the K DAC values for test are measured, wherein K is a positive integer smaller than I. Then, a main output power function is determined according to K DAC values for test and K output powers for test. Next, I corrected DAC control values corresponding to I normal output powers are obtained according to main output power function, wherein the I normal output powers satisfy a communication specification. Thereafter, the I DAC control values are replaced with the I corrected DAC control values, and the I corrected DAC control values are stored in the mobile telephone.

The invention also achieves the above-identified object by providing a correction system for correcting a mobile telephone having an automatic power control function. The system corrects I output powers of an antenna corresponding to I power control levels of a mobile telephone, wherein I is a positive integer. I DAC (digital-to-analog conversion) control values for determining I output powers are stored in the mobile telephone. The correction system of the invention includes a radio signal measurement apparatus and a host. The radio signal measurement apparatus measures an output power emitted from the mobile telephone. The host corrects the mobile telephone and is electrically coupled to the radio signal measurement apparatus. The host and the radio signal measurement apparatus execute the following steps to correct the mobile telephone. First, the host arbitrarily selects K DAC control values for test. Then, the radio signal measurement apparatus measures K output powers for test of the mobile telephone corresponding to the K DAC values for test, wherein K is a positive integer smaller than I. Thereafter, the host determines a main output power function according to the K DAC values for test and the K output powers for test. Next, the host obtains I corrected DAC control values corresponding to I normal output powers according to the main output power function, wherein the I normal output powers satisfy a communication specification. Then, the host replaces the I DAC control values with the I corrected DAC control values and stores the I corrected DAC control values in the mobile telephone.

Other objects, features, and advantages of the invention will become apparent from the following detailed description of the preferred but non-limiting embodiments. The following description is made with reference to the accompanying drawings.

BRIEF DESCRIPTION OF THE DRAWINGS

FIG. 1 is a schematic illustration showing a conventional production line for performing a radio frequency (RF) correction.

FIG. 2A is a graph showing a relationship between a power of the burst with respect to time.

FIG. 2B shows a look-up table created according to 32 power control levels and the normal output powers of the mobile telephone in the GSM400/GSM900/GSM850 system.

FIG. 3 is a block diagram showing a portion of the system of the mobile telephone for generating the burst of FIG. 2A.

FIG. 4 illustrates characteristic curves corresponding to two mobile telephones, respectively.

FIG. 5 is a block diagram showing a correction system for correcting a mobile telephone having an automatic power control function according to a preferred embodiment of the invention.

FIG. 6 is a flow chart showing a first correction method executed by the correction system of FIG. 5.

FIG. 7 is a flow chart showing a second correction method of the invention.

FIGS. 8A to 8C shows an example of function curves of a main output power function P(x) and a fine tuning output power function Pf(x) for implementing the second correction method of the invention.

FIG. 9 is a schematic illustration showing a production line on which a radio frequency correction of the invention is performed.

DETAILED DESCRIPTION OF THE INVENTION

The invention uses a main output power function to represent the characteristic curves of the mobile telephones, and obtains proper DAC control values according to the main output power function so as to quickly finish the correction operation and enhance the product yield.

FIG. 5 is a block diagram showing a correction system 500 for correcting a mobile telephone 506 having an automatic power control function according to a preferred embodiment of the invention. The mobile telephone 506 has an RF antenna and a DAC control value register. Referring to FIG. 5, the correction system 500 of the invention includes a radio signal measurement apparatus 502 and a host 504. The correction system 500 corrects I output powers of the RF antenna of the mobile telephone 506 corresponding to I power control levels of the mobile telephone 506, wherein I is a positive integer. In the ETSI power control specification, I is equal to 32. I DAC (digital-to-analog conversion) control values for determining the I output powers are stored in the DAC control value register of the mobile telephone 506. The radio signal measurement apparatus 502 measures an output power emitted from the mobile telephone 506. The host 504 has an RF correction software system for correcting the mobile telephone 506 and receiving a measurement result from the radio signal measurement apparatus 502.

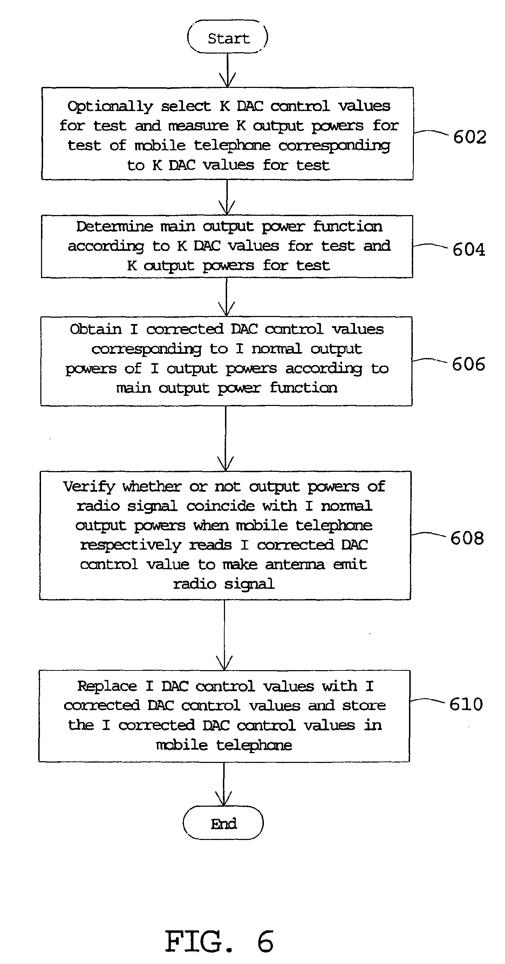

FIG. 6 is a flow chart showing a first correction method executed by the correction system 500 of FIG. 5. When the correction is performed, step 602 is first performed, wherein the host 504 arbitrarily selects K DAC control values D(1) to D(K) for test. Then, the radio signal measurement apparatus 502 measures K output powers PHY(1) to PHY(K) for test corresponding to the K DAC values D(1) to D(K) for test, wherein K is a positive integer smaller than I. That is, a power level converter processes the K DAC values D(1) to D(K) for test to make the RF antenna of the mobile telephone 506 output K corresponding output powers PHY(1) to PHY(K). Then, the radio signal measurement apparatus 502 measures K output powers of the RF antenna to obtain K output powers PHY(1) to PHY(K) for test and records them in the host 504. The K DAC control values D(1) to D(k) for test may be selected from the I DAC control values that are originally stored in a DAC control value register of the mobile telephone 506.

Next, step 604 is performed, wherein the host 504 determines a main output power function P(x) according to the K DAC values D(1) to D(K) for test and the K output powers PHY(1) to PHY(K) for test. The main output power function P(x) is a polynomial function as set forth below.

$$P(x) = a_r{}^*x^r + a_{r-1}{}^*x^{r-1} + ... + a_1{}^*x + a_0 \ (Equation \ 1),$$

wherein "x" represents the DAC control value and "r" represents the positive integer. The coefficients $a_r$ to $a_0$ of the polynomial function may be obtained by substituting "x" for D(1) to D(K) and substituting P(x) for PHY(1) to PHY(K), respectively.

Then, the process goes to step 606, wherein the host 504 obtains I corrected DAC control values CD(1) to CD(I) corresponding to I normal output powers N(1) to N(I) according to main output power function P(x). The I normal output powers N(1) to N(I) satisfy the communication specification such as the ETSI power control specification. For example, the I normal output powers may be 32 normal output powers corresponding to 32 power control levels shown in FIG. 2B, wherein a portion of the power control levels corresponds to the same normal output power. In step 606, the x value, which is equal to CD(1), may be obtained by setting P(x)=N(1). Then, other x values, which are equal to CD(2) to CD(I), may be obtained by setting P(x)=N(2), N(3)...N(I), respectively.

Thereafter, step 608 is performed. When the power level converter of the mobile telephone 506 reads the I corrected DAC control values CD(1) to CD(I), respectively, to make the RF antenna emit radio signals, the output powers PW(1) to PW(I) of the radio signals are verified to determined whether or not they coincide with the I normal output powers N(1) to N(I). That is, step 608 judges whether or not PW(1) to PW(I) approximate N(1) to N(I), and whether or not the differences therebetween are smaller than the tolerances of the normal output powers. If yes, it means that the I corrected DAC control values CD(1) to CD(I) make the output power of the emitted radio signals from the mobile telephone 506 satisfy the requirement of the communication protocol. At this time, step 610 may be performed next, wherein the host 504 replaces the I DAC control values D(1) to D(I), which are originally stored in the DAC control value register with I corrected DAC control values CD(1) to CD(I), and then stores the I corrected DAC control values CD(1) to CD(I) in the DAC control value register of the mobile telephone 506.

If the output powers PW(1) to PW(I) do not coincide with the normal output powers N(1) to N(I) corresponding to any one of the I corrected DAC control values CD(1) to CD(I), the second correction method of the invention may be adopted for fine tuning. In addition, if the correction wants to be performed more precisely, it is also possible to use the second correction method of the invention.

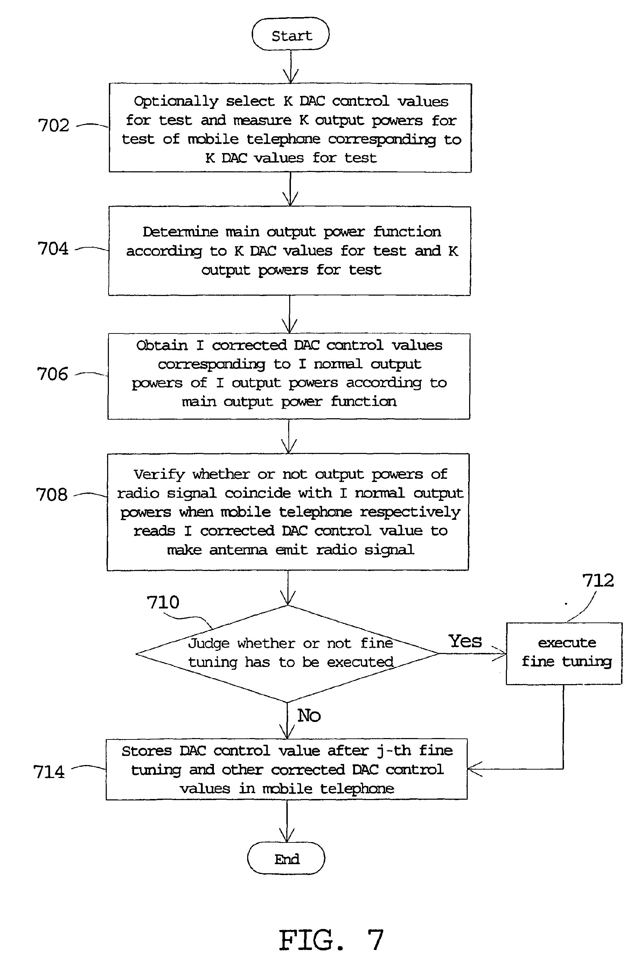

FIG. 7 is a flow chart showing a second correction method of the invention. Steps 702 to 708 are the same as steps 602 to 608, respectively, and descriptions thereof will be omitted. Step 710 is performed after step 708, wherein it judges whether or not the fine tuning has to be performed. It is assumed that the DAC control value CD(j) after the j-th correction is one of the I corrected DAC control values CD(1) to CD(I). When the step 710 judges that the j-th output power PW(j) corresponding to the DAC control value CD(j) after the j-th correction does not coincide with the j-th normal output power N(j), the fine tuning should be performed, and the process goes to step 712; or otherwise, the process goes to step 714.

In step 712, the fine tuning process is performed by the following steps. First, the host 504 determines a fine tuning output power function Pf(x) according to the DAC control value CD(j), the j-th output power PW(j), and the j-th normal output power N(j) after the j-th correction. The fine tuning output power function Pf(x) is a polynomial function as set forth below.

$$Pf(x) = b_s*x^s + b_{s-1}*x^{s-1} + ...+ b_1*x + b_0 \text{ (Equation 2)},$$

wherein the coefficients $b_s$ to $b_1$ may be obtained by setting x=CD(j) and Pf(x)=PW(j) and using the j-th normal output power N(j), and the value s is smaller than the value r. Because the fine tuning output power function Pf(x) possesses the characteristic curve locality, the polynomial with a smaller power may be used for the Pf(x) to approximate the characteristic curve in the vicinity of the DAC control value CD(j) after the j-th correction.

Then, the host 504 derives the DAC control value FD(j) after the j-th fine tuning from the fine tuning output power function Pf(x) according to the j-th normal output power N(j). That is, let Pf(x)=N(j), "x" is solved. The x value is the desired DAC control value FD(j) after the j-th fine tuning. Then the process goes to step 714.

In step 714, the host 504 replaces the DAC control value CD(j) after the j-th correction with the DAC control value FD(j) after the j-th fine tuning, and stores the DAC control value FD(j) in the DAC control value register of the mobile telephone 506. Other DAC control values after corrections are also simultaneously stored in the DAC control value register of the mobile telephone 506.

In addition, in step 710, even if all of the output powers PW(1) to PW(I) corresponding to the corrected DAC control values CD(1) to CD(I) coincide with the normal output powers N(1) to N(I), fine tuning may also be performed to obtain more precise DAC control values FD(1) to FD(I). Step 712 is executed for fine tuning if the j-th output power PW(j) corresponding to the DAC control value CD(j) after the j-th correction is requested to more precisely approximate the j-th normal output power N(j). Similarly, the above-mentioned fine tuning method also may be utilized to obtain the DAC control value FD(j) after the j-th fine tuning. Then, the process goes to step 714, wherein the host 504 replaces the DAC control value CD(j) after the j-th correction with the DAC control value FD(j) after the j-th fine tuning, and stores the DAC control value FD(j) in the DAC control value register of the mobile telephone 506.

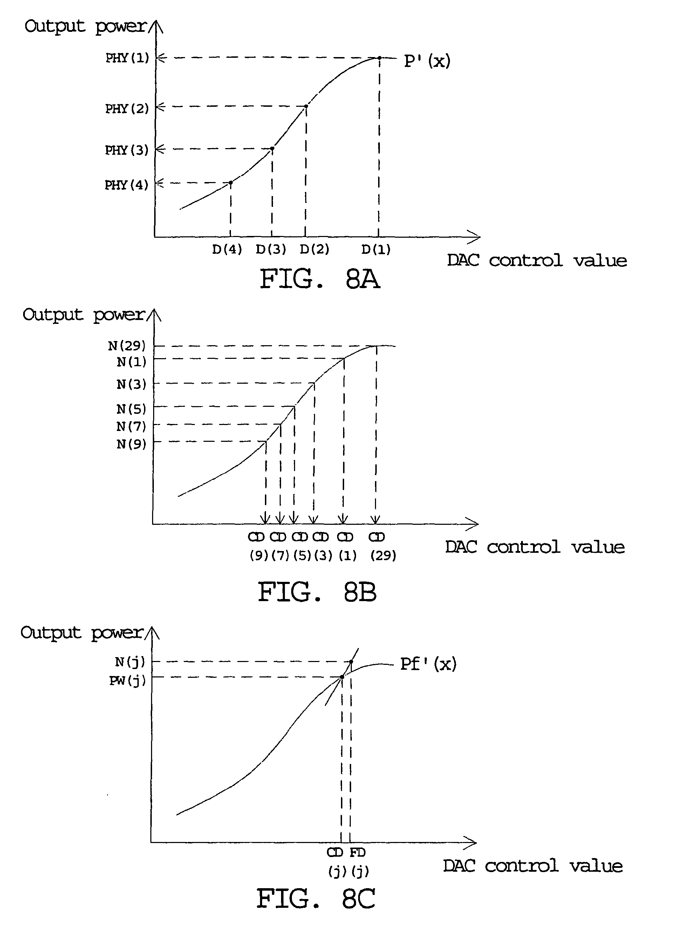

An example of the second correction method of the invention will be described in the following. FIGS. 8A to 8C shows an example of function curves of a main output power function P(x) and a fine tuning output power function Pf(x) for implementing the second correction method of the invention. Let us assume that K=4, and I=32. After the steps 702 and 704 are performed, four DAC control values D(1) to D(4) for test and four output powers PHY(1) to PHY(4) for test, which are measured by the radio signal measurement apparatus 502, determine the main output power function P'(x), as shown in FIG. 8A. When the step 706 is finished, the host 504 derives 32 corrected DAC control values CD(1) to CD(32) from 32 normal output powers N(1) to N(32) according to the main output power function P'(x), as shown in FIG. 8B. FIG. 8B only illustrates six sets of normal output powers and corrected DAC control values.

After the fine tuning step of step 712 is finished, the host 504 obtains the fine tuning output power function Pf(x) according to the DAC control value CD(j), the j-th output power PW(j), and the j-th normal output power N(j) after the j-th correction. Then, the host 504 derives the DAC control value FD(j) after the j-th fine tuning from the fine tuning output power function Pf(x) according to j-th normal output power N(j). The DAC control value FD(j) after the j-th fine tuning and other corrected DAC control values are stored in the DAC control value register of the mobile telephone 506 to complete the correction. The corrected mobile telephone 506 can precisely emit output powers satisfying each power control level of the communication protocol.

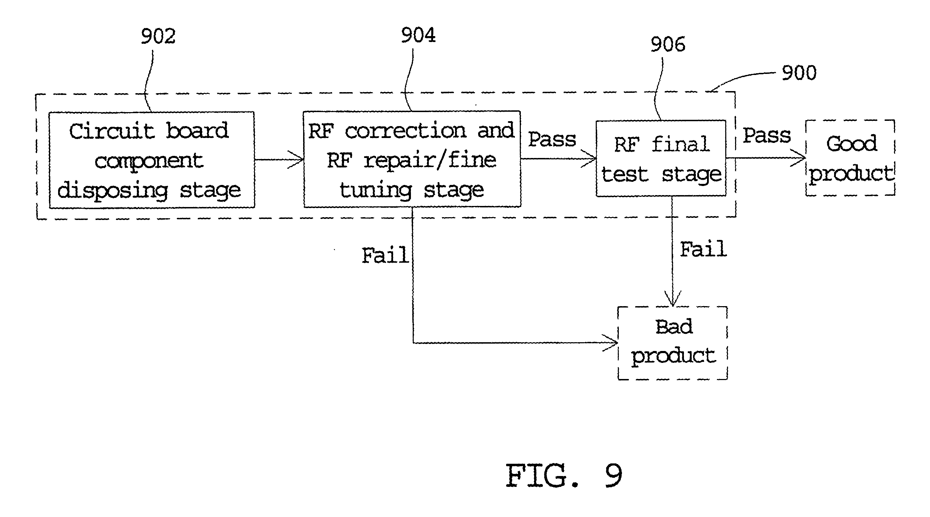

FIG. 9 is a schematic illustration showing a production line 900 on which a radio frequency correction of the invention is performed. The production and correction procedures using the correction method and system of the invention are as follows. First, main components of the mobile telephone are mounted to the circuit board in a circuit board component disposing stage 902. Next, the correction system 500 of the invention executes the first or second correction method to correct the mobile telephone 506 in an RF correction and RF repair/fine tuning stage 904. If the correction fails, the mobile telephone 506 is a defected product. If the correction succeeds, the mobile telephone 506 is transferred to the RF final test stage 906 for testing the overall mobile telephone 506.

Unlike the conventional method of FIG. 1 in which the circuit board has to be moved out of the production line so that it can be repaired and finely tuned, the invention completes the correction and fine tuning operations in the RF correction and RF repair/fine tuning stage 904. In addition, since the invention can obtain all of the corrected DAC control values and finely tuned DAC control values by merely measuring several output powers for test, the correction may be quickly and advantageously completed. The actual operation results after the invention is applied to the production line indicate that the product yield is greatly enhanced since the precision of the DAC control value stored in the DAC control value register after the correction is enhanced.

While the invention has been described by way of example and in terms of a preferred embodiment, it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

**Claims**

1. A method for correcting a mobile telephone having an Automatic Power Control (APC) function and for correcting I output powers of an antenna corresponding to I power control levels of the mobile telephone, wherein I is a positive integer, and I DAC (digital-to-analog conversion) control values for determining the I output powers are stored in the mobile telephone, the method comprising the steps of:

   (a) arbitrarily selecting K DAC control values for test, and measuring K output powers for test of the mobile telephone corresponding to the K DAC values for test (702), K being a positive integer smaller than I;
   (b) determining a main output power function according to the K DAC values for test and the K output powers for test (704);
   (c) obtaining I corrected DAC control values corresponding to I normal output powers according to the main output power function (706), the I normal output powers satisfying a communication specification; and
   (d) replacing the I DAC control values with the I corrected DAC control values and storing the I corrected DAC control values in the mobile telephone (714),

   **characterized in that** the main output power function is a polynomial function, and in step (b), all coefficients of the polynomial function are determined according to the K DAC values for test and the K output powers for test.

2. The method according to claim 1, wherein the K DAC control values for test are selected from the I DAC control values.

3. The method according to claim 1, further comprising, between steps (c) and (d), a step of:

   (c1) verifying whether or not output powers of radio signals coincide with the I normal output powers, respectively, when the mobile telephone respectively reads the I corrected DAC control values to make the antenna emit the radio signals, and executing step (d) if the output powers coincide with the I normal output powers (708).

4. The method according to claim 3, further comprising, after step (c1), the steps of:

   (c2) executing steps (c3) and (c4) when a j-th output power corresponding to a DAC control value after a j-th correction does not coincide with a j-th normal output power, wherein the DAC control value after the j-th correction is one of the I corrected DAC control values;
   (c3) determining a fine tuning output power function according to the DAC control value, the j-th output power, and the j-th normal output power after the j-th correction; and
   (c4) deriving a DAC control value after a j-th fine tuning from the fine tuning output power function according to the j-th normal output power, wherein in step (d), the DAC control value after the j-th correction is replaced with the DAC control value after the j-th fine tuning, and the DAC control value after the j-th fine tuning is stored in the mobile telephone.

5. The method according to claim 3, further comprising, after step (c1), the steps of:

   (c2) executing steps (c3) and (c4) when a j-th output power corresponding to a DAC control value after a j-th correction is requested to more precisely approximate a j-th normal output power, wherein the DAC control value after the j-th correction is one of the I corrected DAC control values;
   (c3) determining a fine tuning output power function according to the DAC control value, the j-th output power, and the j-th normal output power after the j-th correction; and
   (c4) deriving a DAC control value after a j-th fine tuning from the fine tuning output power function according to the j-th normal output power,

   wherein in step (d), the DAC control value after the j-th correction is replaced with the DAC control value after the j-th fine tuning, and the DAC control value after the j-th fine tuning is stored in the mobile telephone.

**6.** A correction system for correcting a mobile telephone (506) having an Automatic Power Control (APC) function and for correcting I output powers of an antenna (312) corresponding to I power control levels of the mobile telephone, wherein I is a positive integer, and I DAC (digital-to-analog conversion) control values for determining the I output powers are stored in the mobile telephone, the correction system comprising:

a radio signal measurement apparatus (502) for measuring output powers emitted from the mobile telephone; and a host (504) for correcting the mobile telephone, the host being electrically coupled to the radio signal measurement apparatus, wherein the host and the radio signal measurement apparatus execute the following steps to correct the mobile telephone:

(a) causing the host to arbitrarily select K DAC control values for test, and then the radio signal measurement apparatus to measure K output powers for test of the mobile telephone corresponding to the K DAC values for test, K being a positive integer smaller than I;

(b) causing the host to determine a main output power function according to the K DAC values for test and the K output powers for test;

(c) causing the host to obtain I corrected DAC control values corresponding to I normal output powers according to the main output power function, the I normal output powers satisfying a communication specification; and

(d) causing the host to replace the I DAC control values with the I corrected DAC control values and to store the I corrected DAC control values in the mobile telephone,

**characterized in that** the main output power function is a polynomial function, and in step (b), the host determines all coefficients of the polynomial function according to the K DAC values for test and the K output powers for test.

**7.** The correction system according to claim 6, wherein the K DAC control values for test are selected from the I DAC control values.

**8.** The correction system according to claim 6, wherein the host and the radio signal measurement apparatus further execute the following step between steps (c) and (d) to correct the mobile telephone:

(c1) verifying whether or not output powers of radio signals, which are measured by the radio signal measurement apparatus, coincide with the I normal output powers, respectively, when the mobile telephone respectively reads the I corrected DAC control values to make the antenna emit the radio signals.

**9.** The correction system according to claim 8, wherein the host and the radio signal measurement apparatus further execute the following steps after step (c1) to correct the mobile telephone:

(c2) executing steps (c3) and (c4) when a j-th output power corresponding to a DAC control value after a j-th correction does not coincide with a j-th normal output power, wherein the DAC control value after the j-th correction is one of the I corrected DAC control value; and

(c3) causing the host to determine a fine tuning output power function according to the DAC control value, the j-th output power, and the j-th normal output power after the j-th correction; and

(c4) causing the host to derive a DAC control value after a j-th fine tuning from the fine tuning output power function according to the j-th normal output power, wherein in step (d), the host replaces the DAC control value after the j-th correction with the DAC control value after the j-th fine tuning, and stores the DAC control value after the j-th fine tuning in the mobile telephone.

**10.** The correction system according to claim 8, wherein the host and the radio signal measurement apparatus further execute the following steps after step (c1) to correct the mobile telephone:

(c2) executing steps (c3) and (c4) when a j-th output power corresponding to a DAC control value after a j-th correction is requested to more precisely approximate a j-th normal output power, wherein the DAC control value after the j-th correction is one of the I corrected DAC control values;

(c3) causing the host to determine a fine tuning output power function according to the DAC control value, the j-th output power, and the j-th normal output power after the j-th correction; and

(c4) causing the host to derive a DAC control value after a j-th fine tuning from the fine tuning output power function according to the j-th normal output power,

wherein in step (d), the host replaces the DAC control value after the j-th correction with the DAC control value after the j-th fine tuning, and stores the DAC control value after the j-th fine tuning in the mobile telephone.

**Patentansprüche**

1. Verfahren zum Korrigieren eines Mobiltelefons mit einer automatischen Leistungssteuerungs- (APC-) Funktion und zum Korrigieren von I Sendeleistungen einer Antenne, die zu I Leistungssteuerungspegeln des Mobiltelefons korrespondieren, wobei I eine positive Ganzzahl ist und I DAC-(digital-analog Umwandlungs-) Steuerwerte zur Ermittlung der I Sendeleistungen im Mobiltelefon gespeichert werden, wobei das Verfahren die Schritte umfasst:

   (a) willkürliches Auswählen von K Test-DAC-Steuerwerten und Messen von K Test-Sendeleistungen des Mobiltelefons, die zu den K Test-DAC-Steuerwerten (702) korrespondieren, wobei K eine positive Ganzzahl kleiner als I ist;
   (b) Ermitteln einer Haupt-Sendeleistungsfunktion gemäß den K Test-DAC-Werten und den K Test-Sendeleistungen (704);
   (c) Erhalten von I korrigierten DAC-Steuerwerten gemäß der Haupt-Sendeleistungsfunktion (706), die zu I Normal-Sendeleistungen korrespondieren, wobei die I Normal-Sendeleistungen eine Kommunikationsspezifikation erfüllen; und
   (d) Ersetzen der I DAC-Steuerwerte durch die I korrigierten DAC-Steuerwerte und Abspeichern der I korrigierten DAC-Steuerwerte im Mobiltelefon (714),

   **dadurch gekennzeichnet, dass** die Haupt-Sendeleistungsfunktion eine polynomiale Funktion ist und im Schritt (b) alle Koeffizienten der polynomialen Funktion gemäß den K Test-DAC-Steuerwerten und den K Test-Sendeleistungen ermittelt werden.

2. Verfahren nach Anspruch 1, wobei die K Test-DAC-Steuerwerte aus den I DAC-Steuerwerten ausgewählt werden.

3. Verfahren nach Anspruch 1, das ferner zwischen den Schritten (c) und (d) folgenden Schritt umfasst:

   (c1) Verifizieren, ob Sendeleistungen von Funksignalen jeweils mit den I Normal-Sendeleistungen übereinstimmen, oder nicht, wenn das Mobiltelefon jeweils die I korrigierten DAC-Steuerwerte liest, damit die Antenne die Funksignale emittiert, und Ausführen des Schritts (d), wenn die Sendeleistungen mit den I Normal-Sendeleistungen (708) übereinstimmen.

4. Verfahren nach Anspruch 3, das ferner nach dem Schritt (c1) folgende Schritte aufweist:

   (c2) Ausführen von Schritten (c3) und (c4), wenn eine j-te Sendeleistung, die zu einem DAC-Steuerwert nach einer j-ten Korrektur korrespondiert, nicht einer j-ten Normal-Sendeleistung übereinstimmt, wobei der DAC-Steuerwert nach der j-ten Korrektur einer der I korrigierten DAC-Steuerwerte ist.
   (c3) Ermitteln einer Feinabstimmungs-Sendeleistungsfunktion gemäß dem DAC-Steuerwert, der j-ten Sendeleistung und der j-ten Normal-Sendeleistung nach der j-ten Korrektur; und
   (c4) Ableiten eines DAC-Steuerwerts nach einer j-ten Feinabstimmung aus der Feinabstimmungs-Sendeleistungsfunktion gemäß der j-ten Normal-Sendeleistung, wobei im Schritt (d) der DAC-Steuerwert nach der j-ten Korrektur durch den DAC-Steuerwert nach der j-ten Feinabstimmung ersetzt wird und der DAC-Steuerwert nach der j-ten Feinabstimmung im Mobiltelefon gespeichert wird.

5. Verfahren nach Anspruch 3 das ferner nach dem Schritt (c1) folgende Schritte aufweist:

   (c2) Ausführen der Schritte (c3) und (c4), wenn eine zu einem DAC-Steuerwert korrespondierende j-te Sendeleistung nach einer j-ten Korrektur angefordert wird, um eine j-te Normal-Sendeleistung präziser anzunähern, wobei der DAC-Steuerwert nach der j-ten Korrektur einer der I korrigierten DAC-Steuerwerte ist;
   (c3) Ermitteln einer Feinabstimmungs-Sendeleistungsfunktion gemäß dem DAC-Steuerwert, der j-ten Sendeleistung und der j-ten Normal-Sendeleistung nach der j-ten Korrektur; und
   (c4) Ableiten eines DAC-Steuerwerts nach einer j-ten Feinabstimmung aus der Feinabstimmungs-Sendeleistungsfunktion gemäß der j-ten Normal-Sendeleistung,

   wobei im Schritt (d) der DAC-Steuerwert nach der j-ten Korrektur durch den DAC-Steuerwert nach der j-ten Feinabstimmung ersetzt wird und der DAC-Steuerwert nach der j-ten Feinabstimmung im Mobiltelefon gespeichert wird.

6. Korrektursystem zum Korrigieren eines Mobiltelefons (506) mit einer automatischen Leistungssteuerungs- (APC-) Funktion und zum Korrigieren von I Sendeleistungen einer Antenne (312), die zu I Leistungssteuerungspegeln des Mobiltelefons korrespondieren, wobei I eine positive Ganzzahl ist und I DAC- (digital-analog Umwandlungs-) Steuerwerte zur Ermittlung der I Sendeleistungen im Mobiltelefon gespeichert werden, wobei das Korrektursystem umfasst:

   eine Funksignal-Messvorrichtung (502) zum Messen von Sendeleistungen, die vom Mobiltelefon emittiert werden; und
   einen Host (504) zum Korrigieren des Mobiltelefons, wobei der Host mit der Funksignal-Messvorrichtung elektrisch verbunden ist, wobei der Host und die Funksignal-Messvorrichtung die nachfolgenden Schritte ausführen, um das Mobiltelefon zu korrigieren;

   (a) Bewirken, dass der Host willkürlich K Test-DAC-Steuerwerte auswählt und dass die Funksignal-Messvorrichtung danach K Test-Sendeleistungen des Mobiltelefons misst, die zu den K Test-DAC-Steuerwerten korrespondieren, wobei K eine positive Ganzzahl kleiner als I ist;
   (b) Bewirken, dass der Host eine Haupt-Sendeleistungsfunktion gemäß den K Test-DAC-Werten und den K Test-Sendeleistungen ermittelt;
   (c) Bewirken, dass der Host I korrigierte DAC-Steuerwerte gemäß der Haupt-Sendeleistungsfunktion erhält, die zu I Normal-Sendeleistungen korrespondieren, wobei die I Normal-Sendeleistungen eine Kommunikationsspezifikation erfüllen; und
   (d) Bewirken, dass der Host die I DAC-Steuerwerte durch die I korrigierten DAC-Steuerwerte ersetzt und die I korrigierten DAC-Steuerwerte im Mobiltelefon speichert,

   **dadurch gekennzeichnet, dass** die Haupt-Sendeleistungsfunktion eine polynomiale Funktion ist und der Host im Schritt (b) alle Koeffizienten der polynomialen Funktion gemäß den K Test-DAC-Steuerwerten und den K Test-Sendeleistungen für einen Test ermittelt.

7. Korrektursystem nach Anspruch 6, wobei die K Test-DAC-Steuerwerte aus den I DAC-Steuerwerten ausgewählt werden.

8. Korrektursystem nach Anspruch 6, wobei der Host und die Funksignal-Messvorrichtung ferner den nachfolgenden Schritt zwischen den Schritten (c) und (d) ausführen, um das Mobiltelefon zu korrigieren:

   (c1) Verifizieren, ob Sendeleistungen von Funksignalen, die von der Funksignal-Messvorrichtung gemessen wurden, jeweils mit den I Normal-Sendeleistungen übereinstimmen, oder nicht, wenn das Mobiltelefon jeweils die I korrigierten DAC-Steuerwerte liest, damit die Antenne die Funksignale emittiert.

9. Korrektursystem nach Anspruch 8, wobei der Host und die Funksignal-Messvorrichtung ferner die nachfolgenden Schritte nach dem Schritt (c1) ausführen, um das Mobiltelefon zu korrigieren:

   (c2) Ausführen von Schritten (c3) und (c4), wenn eine j-te Sendeleistung, die zu einem DAC-Steuerwert korrespondiert, nach einer j-ten Korrektur nicht mit einer j-ten Normal-Sendeleistung übereinstimmt, wobei der DAC-Steuerwert nach der j-ten Korrektur einer der I korrigierten DAC-Steuerwerte ist; und
   (c3) Bewirken, dass der Host eine Feinabstimmungs-Sendeleistungsfunktion gemäß dem DAC-Steuerwert, der j-ten Sendeleistung und der j-ten Normal-Sendeleistung nach der j-ten Korrektur ermittelt; und
   (c4) Bewirken, dass der Host einen DAC-Steuerwert nach einer j-ten Feinabstimmung aus der Feinabstimmungs-Sendeleistungsfunktion gemäß der j-ten Normal-Sendeleistung ableitet, wobei der Host im Schritt (d) den DAC-Steuerwert nach der j-ten Korrektur durch den DAC-Steuerwert nach der j-ten Feinabstimmung ersetzt und den DAC-Steuerwert nach der j-ten Feinabstimmung im Mobiltelefon speichert.

10. Korrektursystem nach Anspruch 8, wobei der Host und die Funksignal-Messvorrichtung ferner die nachfolgenden Schritte nach dem Schritt (c1) ausführen, um das Mobiltelefon zu korrigieren:

   (c2) Ausführen von Schritten (c3) und (c4), wenn eine j-te Sendeleistung, die zu einem DAC-Steuerwert nach einer j-ten Korrektur korrespondiert, angefordert wird, um eine j-te Normal-Sendeleistung präziser anzunähern, wobei der DAC-Steuerwert nach der j-ten Korrektur einer der I korrigierten DAC-Steuerwerte ist;

(c3) Bewirken, dass der Host eine Feinabstimmungs-Sendeleistungsfunktion gemäß dem DAC-Steuerwert, der j-ten Sendeleistung und der j-ten Normal-Sendeleistung nach der j-ten Korrektur ermittelt; und

(c4) Bewirken, dass der Host einen DAC-Steuerwert nach einer j-ten Feinabstimmung aus der Feinabstimmungs-Sendeleistungsfunktion gemäß der j-ten Normal-Sendeleistung ableitet,

wobei der Host in einem Schritt (d) den DAC-Steuerwert nach der j-ten Korrektur durch den DAC-Steuerwert nach der j-ten Feinabstimmung ersetzt und den DAC-Steuerwert nach der j-ten Feinabstimmung im Mobiltelefon speichert.

## Revendications

1. Procédé destiné à corriger un téléphone mobile présentant une fonction de commande de puissance automatique (APC) et destiné à corriger I puissances de sortie d'une antenne correspondant à I niveaux de commande de puissance du téléphone mobile, dans lequel I est un nombre entier positif, et dans lequel I valeurs de commande de conversion DAC (conversion numérique à analogique) destinées à déterminer les I puissances de sortie sont stockées dans le téléphone mobile, le procédé comportant les étapes ci-dessous consistant à :

(a) sélectionner arbitrairement K valeurs de commande de conversion DAC à tester, et mesurer K puissances de sortie à tester du téléphone mobile correspondant aux K valeurs de conversion DAC à tester (702), K étant un nombre entier positif inférieur à I ;

(b) déterminer une fonction de puissance de sortie principale selon les K valeurs de conversion DAC à tester et les K puissances de sortie à tester (704);

(c) obtenir I valeurs de commande de conversion DAC corrigées correspondant à I puissances de sortie normales selon la fonction de puissance de sortie principale (706), les I puissances de sortie normales satisfaisant une spécification de communication ; et

(d) remplacer les I valeurs de commande de conversion DAC par les I valeurs de commande de conversion DAC corrigées et stocker les I valeurs de commande de conversion DAC corrigées dans le téléphone mobile (714) ;

**caractérisé en ce que** la fonction de puissance de sortie principale est une fonction polynomiale, et au cours de l'étape (b), l'ensemble des coefficients de la fonction polynomiale sont déterminés selon les K valeurs de conversion DAC à tester et les K puissances de sortie à tester.

2. Procédé selon la revendication 1, dans lequel les K valeurs de commande de conversion DAC à tester sont sélectionnées à partir des I valeurs de commande de conversion DAC.

3. Procédé selon la revendication 1, comportant en outre, entre les étapes (c) et (d), une étape consistant à :

(c1) vérifier si les puissances de sortie de signaux radio coïncident ou non avec les I puissances de sortie normales, respectivement, lorsque le téléphone mobile respectivement lit les I valeurs de commande de conversion DAC corrigées afin d'amener l'antenne à émettre les signaux radio, et exécuter l'étape (d) si les puissances de sortie coïncident avec les I puissances de sortie normales (708).

4. Procédé selon la revendication 3, comportant en outre, à l'issue de l'étape (c1), les étapes ci-dessous consistant à :

(c2) mettre en oeuvre les étapes (c3) et (c4) lorsqu'une j-ième puissance de sortie correspondant à une valeur de commande de conversion DAC à l'issue d'une j-ième correction ne coïncide pas avec une j-ième puissance de sortie normale, dans lequel la valeur de commande de conversion DAC à l'issue de la j-ième correction est l'une des I valeurs de commande de conversion DAC corrigées ;

(c3) déterminer une fonction de syntonisation fine de puissance de sortie selon la valeur de commande de conversion DAC, la j-ième puissance de sortie, et la j-ième puissance de sortie normale à l'issue de la j-ième correction ; et

(c4) calculer une valeur de commande de conversion DAC à l'issue d'une j-ième syntonisation fine à partir de la fonction de syntonisation fine de puissance de sortie selon la j-ième puissance de sortie normale, dans lequel, au cours de l'étape (d), la valeur de commande de conversion DAC à l'issue de la j-ième correction est remplacée par la valeur de commande de conversion DAC à l'issue de la j-ième syntonisation fine, et la valeur de commande de conversion DAC à l'issue de la j-ième syntonisation fine est stockée dans le téléphone mobile.

**5.** Procédé selon la revendication 3, comportant en outre, à l'issue de l'étape (c1), les étapes ci-dessous consistant à :

(c2) mettre en oeuvre les étapes (c3) et (c4) lorsqu'une j-ième puissance de sortie correspondant à une valeur de commande de conversion DAC à l'issue d'une j-ième correction est requise en vue d'approximer plus précisément une j-ième puissance de sortie normale, dans lequel la valeur de commande de conversion DAC à l'issue de la j-ième correction est l'une des I valeurs de commande de conversion DAC corrigées ;
(c3) déterminer une fonction de syntonisation fine de puissance de sortie selon la valeur de commande de conversion DAC, la j-ième puissance de sortie, et la j-ième puissance de sortie normale à l'issue de la j-ième correction ; et
(c4) calculer une valeur de commande de conversion DAC à l'issue d'une j-ième syntonisation fine à partir de la fonction de syntonisation fine de puissance de sortie selon la j-ième puissance de sortie normale ;

dans lequel, au cours de l'étape (d), la valeur de commande de conversion DAC à l'issue de la j-ième correction est remplacée par la valeur de commande de conversion DAC à l'issue de la j-ième syntonisation fine, et la valeur de commande de conversion DAC à l'issue de la j-ième syntonisation fine est stockée dans le téléphone mobile.

**6.** Système de correction destiné à corriger un téléphone mobile (506) présentant une fonction de commande de puissance automatique (APC) et destiné à corriger I puissances de sortie d'une antenne (312) correspondant à I niveaux de commande de puissance du téléphone mobile, dans lequel I est un nombre entier positif, et dans lequel I valeurs de commande de conversion DAC (conversion numérique à analogique) destinées à déterminer les I puissances de sortie sont stockées dans le téléphone mobile, le système de correction comportant :

un dispositif de mesure de signaux radio (502) pour mesurer les puissances de sortie émises à partir du téléphone mobile ; et
un hôte (504) destiné à corriger le téléphone mobile, l'hôte étant couplé électriquement au dispositif de mesure de signaux radio, dans lequel l'hôte et le dispositif de mesure de signaux radio mettent en oeuvre les étapes ci-après en vue de corriger le téléphone mobile, consistant à :

(a) amener l'hôte à sélectionner arbitrairement K valeurs de commande de conversion DAC à tester, et ensuite le dispositif de mesure de signaux radio à mesurer K puissances de sortie à tester du téléphone mobile correspondant aux K valeurs de conversion DAC à tester, K étant un nombre entier positif inférieur à I ;
(b) amener l'hôte à déterminer une fonction de puissance de sortie principale selon les K valeurs de conversion DAC à tester et les K puissances de sortie à tester ;
(c) amener l'hôte à obtenir I valeurs de commande de conversion DAC corrigées correspondant à I puissances de sortie normales selon la fonction de puissance de sortie principale, les I puissances de sortie normales satisfaisant une spécification de communication ; et
(d) amener l'hôte à remplacer les I valeurs de commande de conversion DAC par les I valeurs de commande de conversion DAC corrigées et à stocker les I valeurs de commande de conversion DAC corrigées dans le téléphone mobile ;

**caractérisé en ce que** la fonction de puissance de sortie principale est une fonction polynomiale, et au cours de l'étape (b), l'hôte détermine l'ensemble des coefficients de la fonction polynomiale selon les K valeurs de conversion DAC à tester et les K puissances de sortie à tester.

**7.** Système de correction selon la revendication 6, dans lequel les K valeurs de commande de conversion DAC à tester sont sélectionnées à partir des I valeurs de commande de conversion DAC.

**8.** Système de correction selon la revendication 6, dans lequel l'hôte et le dispositif de mesure de signaux radio mettent en outre en oeuvre l'étape ci-après, entre les étapes (c) et (d) destinées à corriger le téléphone mobile, consistant à :

(c1) vérifier si les puissances de sortie de signaux radio, lesquels sont mesurés par le dispositif de mesure de signaux radio, coïncident ou non avec les I puissances de sortie normales, respectivement, lorsque le téléphone mobile respectivement lit les I valeurs de commande de conversion DAC corrigées afin d'amener l'antenne à émettre les signaux radio.

**9.** Système de correction selon la revendication 8, dans lequel l'hôte et le dispositif de mesure de signaux radio mettent en outre en oeuvre les étapes ci-après, à l'issue de l'étape (c1) destinée à corriger le téléphone mobile, consistant à :

(c2) mettre en oeuvre les étapes (c3) et (c4) lorsqu'une j-ième puissance de sortie correspondant à une valeur de commande de conversion DAC à l'issue d'une j-ième correction ne coïncide pas avec une j-ième puissance de sortie normale, dans lequel la valeur de commande de conversion DAC à l'issue de la j-ième correction est l'une des I valeurs de commande de conversion DAC corrigées ; et

(c3) amener l'hôte à déterminer une fonction de syntonisation fine de puissance de sortie selon la valeur de commande de conversion DAC, la j-ième puissance de sortie, et la j-ième puissance de sortie normale à l'issue de la j-ième correction ; et

(c4) amener l'hôte à calculer une valeur de commande de conversion DAC à l'issue d'une j-ième syntonisation fine à partir de la fonction de syntonisation fine de puissance de sortie selon la j-ième puissance de sortie normale, dans lequel, au cours de l'étape (d), l'hôte remplace la valeur de commande de conversion DAC à l'issue de la j-ième correction par la valeur de commande de conversion DAC à l'issue de la j-ième syntonisation fine, et stocke la valeur de commande de conversion DAC à l'issue de la j-ième syntonisation fine dans le téléphone mobile.

**10.** Système de correction selon la revendication 8, dans lequel l'hôte et le dispositif de mesure de signaux radio mettent en outre en oeuvre les étapes ci-après, à l'issue de l'étape (c1) destinée à corriger le téléphone mobile, consistant à :

(c2) mettre en oeuvre les étapes (c3) et (c4) lorsqu'une j-ième puissance de sortie correspondant à une valeur de commande de conversion DAC à l'issue d'une j-ième correction est requise en vue d'approximer plus précisément une j-ième puissance de sortie normale, dans lequel la valeur de commande de conversion DAC à l'issue de la j-ième correction est l'une des I valeurs de commande de conversion DAC corrigées ;

(c3) amener l'hôte à déterminer une fonction de syntonisation fine de puissance de sortie selon la valeur de commande de conversion DAC, la j-ième puissance de sortie, et la j-ième puissance de sortie normale à l'issue de la j-ième correction ; et

(c4) amener l'hôte à calculer une valeur de commande de conversion DAC à l'issue d'une j-ième syntonisation fine à partir de la fonction de syntonisation fine de puissance de sortie selon la j-ième puissance de sortie normale ;

dans lequel au cours de l'étape (d), l'hôte remplace la valeur de commande de conversion DAC à l'issue de la j-ième correction par la valeur de commande de conversion DAC à l'issue de la j-ième syntonisation fine, et stocke la valeur de commande de conversion DAC à l'issue de la j-ième syntonisation fine dans le téléphone mobile.

EP 1 589 666 B1

```
       102                    104                      106
                                                                        ┌─ 100
   ┌─────────────────────────────────────────────────────────┐
   │ ┌─────────────┐      ┌──────────┐        ┌──────────┐    │   ┌ ─ ─ ─ ─ ┐
   │ │ Circuit board│      │   RF    │  Pass  │ RF final │ Pass│   Good
   │ │  component   │─────▶│correction│───────▶│test stage│─────▶ product │
   │ │disposing stage│     │  stage  │        │          │    │
   │ └─────────────┘      └──────────┘        └──────────┘    │   └ ─ ─ ─ ─ ┘
   └────────────────────────────│──────▲──────────│──────────┘
                              Fail│    │Pass       │       Fail
                                  │    │           │
                                  │    │           │        ┌ ─ ─ ─ ─ ┐
                                  │ ┌──────────┐   │          Bad
                                  └▶│   RF     │───┘───────▶ product │
                                    │repair/fine│
                              108 ─ │tuning stage│          └ ─ ─ ─ ─ ┘
                                    └──────────┘
```

FIG. 1(PRIOR ART)

FIG. 2A(PRIOR ART)

EP 1 589 666 B1

| Power control level | normal output power(dBm) | Tolerance (dB) | |
|---|---|---|---|
| | | Normal | Extreme |
| 0-2 | 39 | ±2 | ±2,5 |
| 3 | 37 | ±3 | ±4 |
| 4 | 35 | ±3 | ±4 |
| 5 | 33 | ±3 | ±4 |
| 6 | 31 | ±3 | ±4 |
| 7 | 29 | ±3 | ±4 |
| 8 | 27 | ±3 | ±4 |
| 9 | 25 | ±3 | ±4 |
| 10 | 23 | ±3 | ±4 |
| 11 | 21 | ±3 | ±4 |
| 12 | 19 | ±3 | ±4 |
| 13 | 17 | ±3 | ±4 |
| 14 | 15 | ±3 | ±4 |
| 15 | 13 | ±3 | ±4 |
| 16 | 11 | ±5 | ±6 |
| 17 | 9 | ±5 | ±6 |
| 18 | 7 | ±5 | ±6 |
| 19-31 | 5 | ±5 | ±6 |

# FIG. 2B

FIG. 3(PRIOR ART)

EP 1 589 666 B1

FIG. 4

FIG. 5

Start

Optionally select K DAC control values
for test and measure K output powers for
test of mobile telephone corresponding
to K DAC values for test — 602

Determine main output power function
according to K DAC values for test and
K output powers for test — 604

Obtain I corrected DAC control values
corresponding to I normal output
powers of I output powers according to
main output power function — 606

Verify whether or not output powers of
radio signal coincide with I normal
output powers when mobile telephone
respectively reads I corrected DAC
control value to make antenna emit
radio signal — 608

Replace I DAC control values with I
corrected DAC control values and store
the I corrected DAC control values in
mobile telephone — 610

End

# FIG. 6

```
                    ┌─────────┐
                    │  Start  │
                    └────┬────┘
                         │
                         ▼
        ┌───────────────────────────────────┐
        │  Optionally select K DAC control  │
702 ─── │  values for test and measure K    │
        │  output powers for test of mobile │
        │  telephone corresponding to       │
        │  K DAC values for test            │
        └───────────────┬───────────────────┘
                        │
                        ▼
        ┌───────────────────────────────────┐
        │  Determine main output power      │
704 ─── │  function according to K DAC      │
        │  values for test and K output     │
        │  powers for test                  │
        └───────────────┬───────────────────┘
                        │
                        ▼
        ┌───────────────────────────────────┐
        │  Obtain I corrected DAC control   │
        │  values corresponding to I normal │
706 ─── │  output powers of I output powers │
        │  according to main output power   │
        │  function                         │
        └───────────────┬───────────────────┘
                        │
                        ▼
        ┌───────────────────────────────────┐
        │  Verify whether or not output     │
        │  powers of radio signal coincide  │
708 ─── │  with I normal output powers when │
        │  mobile telephone respectively    │
        │  reads I corrected DAC control    │
        │  value to make antenna emit       │
        │  radio signal                     │
        └───────────────┬───────────────────┘
```

710

Judge whether or not fine tuning has to be executed

712

Yes — execute fine tuning

No

714 — Stores DAC control value after j-th fine tuning and other corrected DAC control values in mobile telephone

End

FIG. 7

Output power

PHY(1)

PHY(2)

PHY(3)

PHY(4)

P'(x)

D(4)  D(3)  D(2)        D(1)

DAC control value

## FIG. 8A

Output power

N(29)
N(1)

N(3)

N(5)
N(7)
N(9)

CD  CD  CD  CD    CD        CD
(9)(7)(5)(3)    (1)      (29)

DAC control value

## FIG. 8B

Output power

N(j)
PW(j)

Pf'(x)

CD  FD
(j) (j)

DAC control value

## FIG. 8C

FIG. 9

EP 1 589 666 B1

**EP 1 589 666 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2393595 A